(19) Europäisches Patentamt
European Patent Office
Office européen des brevets

(11) **EP 3 457 153 B1**

(12) **FASCICULE DE BREVET EUROPEEN**

(45) Date de publication et mention de la délivrance du brevet:
**14.09.2022 Bulletin 2022/37**

(21) Numéro de dépôt: **18194516.3**

(22) Date de dépôt: **14.09.2018**

(51) Classification Internationale des Brevets (IPC):
**G01R 31/40** (2020.01)   **H02S 50/10** (2014.01)

(52) Classification Coopérative des Brevets (CPC):
**G01R 31/40; H02S 50/10;** G01R 22/06; Y02E 10/50

(54) **PROCÉDÉ DE MESURE DE LA PERFORMANCE D'UNE CENTRALE À ÉNERGIE RENOUVELABLE, PROCÉDÉ DE DÉTECTION D'UNE ANOMALIE DE FONCTIONNEMENT D'UNE CENTRALE A ÉNERGIE RENOUVELABLE ET DISPOSITIF METTANT EN OEUVRE LESDITS PROCÉDÉS**

MESSVERFAHREN DER LEISTUNG EINES KRAFTWERKS MIT ERNEUERBARER ENERGIE, DETEKTIONSVERFAHREN EINER FUNKTIONSSTÖRUNG EINES KRAFTWERKS MIT ERNEUERBARER ENERGIE UND VORRICHTUNG ZUM UMSETZEN DIESER VERFAHREN

METHOD FOR MEASURING THE PERFORMANCE OF A RENEWABLE ENERGY PLANT, METHOD FOR DETECTING ABNORMAL OPERATION OF A RENEWABLE ENERGY PLANT AND DEVICE IMPLEMENTING SAID METHODS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.09.2017 FR 1758615**

(43) Date de publication de la demande:
**20.03.2019 Bulletin 2019/12**

(73) Titulaire: **Commissariat à l'Energie Atomique et aux Energies Alternatives**
**75015 Paris (FR)**

(72) Inventeurs:
• **HA, Duy Long**
**73000 CHAMBERY LE VIEUX (FR)**
• **GUILLOU, Hervé**
**75015 PARIS (FR)**

(74) Mandataire: **Cabinet Camus Lebkiri**
**25 rue de Maubeuge**
**75009 Paris (FR)**

(56) Documents cités:
**EP-A1- 3 016 278        WO-A1-2011/117485**
**US-A1- 2010 185 337        US-A1- 2016 378 890**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE DE L'INVENTION**

Le domaine technique de l'invention est celui des centrales de production à énergie renouvelable. La présente invention concerne un procédé de surveillance du fonctionnement d'une telle centrale et en particulier procédé de mesure de la performance d'une centrale à énergie renouvelable et un procédé de détection d'une anomalie de fonctionnement, la détection s'opérant à partir de la mesure de la performance. L'invention concerne également un dispositif de mesure de la performance d'une centrale à énergie renouvelable et de détection d'une anomalie de fonctionnement d'une centrale à énergie renouvelable mettant en œuvre lesdits procédés.

**ARRIERE-PLAN TECHNOLOGIQUE DE L'INVENTION**

Les centrales à production d'énergie renouvelable sont des systèmes complexes dont il est difficile de mesurer les performances. Il est pourtant important détecter les anomalies dans le fonctionnement d'une centrale de production, par exemple au moyen d'un indicateur de performance. Or, il n'existe pas aujourd'hui de méthode fiable capable d'attribuer, pour une période de fonctionnement donnée, un indicateur de performance rendant compte de manière fiable du fonctionnement d'une centrale.
US 2010/185337 A1 et EP 3 016 278 A1 divulguent un état de la technique pertinent.
Il existe donc un besoin d'un procédé permettant de mesurer la performance d'une centrale à énergie renouvelable de manière fiable et, éventuellement, de détecter les anomalies dans le fonctionnement de la centrale afin de pouvoir identifier et éventuellement corriger lesdites anomalies. Il existe également un besoins d'un dispositif permettant de mettre en œuvre un tel procédé.

**RESUME DE L'INVENTION**

L'invention offre une solution aux problèmes évoqués précédemment en permettant une mesure de la performance d'une centrale à énergie renouvelable et, à partir de ladite mesure, de détecter une anomalie dans le fonctionnement de ladite centrale. Pour cela, un premier aspect de l'invention concerne un procédé de mesure de la performance d'une centrale à énergie renouvelable comme défini dans la revendication indépendante 1.
Grâce à l'invention, il est possible de mesurer la performance d'une centrale sur une période de production donnée. De plus, la mesure de la performance pour des périodes de production successives permet également de mesurer l'influence des dispositions éventuellement prises pour améliorer le fonctionnement de la centrale. Comme cela sera montré dans la suite, la mesure de la performance peut également permettre de détecter une anomalie de fonctionnement de la centrale. Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.
Avantageusement, l'indicateur de production théorique est fonction de la production théorique sur la période de production $T_{prod}$ calculée à partir du modèle physique de la centrale.
Avantageusement, l'indicateur de production théorique est calculé à partir de la production théorique $p_{th}(t)$ à un instant t maximisant la relation suivante, notée $p_{th}^*$ :

$$\int_0^{T_{prod}} k_3(t)\, p_{th}(t)dt$$

où $k_3(t)$ est un coefficient de pondération positif dépendant du temps et $p_{th}(t)$ est la production théorique à un temps t, l'indicateur de production théorique étant égal à :

$$I_{th}\left(T_{prod}\right) = \int_0^{T_{prod}} p_{th}^*(t)$$

Ainsi, l'indicateur de production théorique $I_{th}$ tient compte du fait qu'il peut être préférable de produire à certains moments de la période de production, par exemple lorsque la demande est importante.

Avantageusement, le procédé comprend également une étape d'affichage de la performance de fonctionnement. Ainsi, il est possible de visualiser, pour la période de production considéré, la performance mesurée.

Avantageusement, l'étape d'affichage comporte :

- une sous-étape d'affichage d'une information concernant la valeur de l'indicateur de production réelle et/ou théorique ; et
- une sous-étape d'affichage d'une information concernant l'évolution d'une ou plusieurs grandeurs physiques associées à la production en énergie sur la période de production $T_{prod}$.

Ainsi, il est possible de connaître les valeurs des grandeurs physiques associées à la production en énergie et éventuellement de les comparer aux valeurs physiques obtenues lors de périodes de production antérieures.

Avantageusement, la centrale à énergie renouvelable comporte au moins une batterie, le procédé étant caractérisé en ce qu'une des grandeurs physiques associées à la production en énergie affichée lors de l'étape d'affichage de la performance de fonctionnement est l'état de charge de la batterie lors de la période de production $T_{prod}$ ainsi que l'état de charge de la batterie théorique pour ladite période. On entend par état de charge théorique, l'état de charge relatif à la production théorique.

Un deuxième aspect de l'invention concerne un procédé de détection d'une anomalie de fonctionnement d'une centrale à énergie renouvelable caractérisé en ce qu'il comprend :

- une étape de mesure de la performance d'une centrale à énergie renouvelable à l'aide d'un procédé selon l'une des revendications précédentes ;
- une étape de détection d'une anomalie de fonctionnement lorsque le rapport entre l'indicateur de performance réel et l'indicateur de performance théorique est inférieur à une valeur prédéterminée.

Ainsi, à partir de la mesure de la performance obtenue à l'aide d'un procédé selon un premier aspect de l'invention, il est possible de détecter un dysfonctionnement éventuel d'une centrale à énergie renouvelable.

Un troisième aspect de l'invention concerne un dispositif de mesure de la performance d'une centrale à énergie renouvelable comme défini dans la revendication indépendante 8.

Avantageusement, le dispositif comprend également des moyens pour détecter une anomalie de fonctionnement lorsque le rapport entre l'indicateur de performance réel et l'indicateur de performance théorique est inférieur à une valeur prédéterminée.

Un quatrième aspect de l'invention concerne un produit programme d'ordinateur comprenant des instructions qui conduisent le dispositif selon un troisième aspect de l'invention à exécuter les étapes du procédé selon l'un premier aspect de l'invention ou un deuxième aspect de l'invention.

Un cinquième aspect de l'invention concerne un support lisible par ordinateur, sur lequel est enregistré le programme d'ordinateur selon un quatrième aspect de l'invention.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 montre un ordinogramme d'un procédé selon un premier aspect de l'invention.
- La figure 2 montre une représentation schématique d'un dispositif selon un troisième aspect de l'invention.
- La figure 3 montre une centrale équipée d'un dispositif selon un troisième aspect de l'invention.
- La figure 4 montre une représentation d'un plan de production pour une période de production donnée.
- La figure 5 montre un affichage de grandeurs physiques associées à une période de production.
- La figure 6 montre l'évolution de la performance d'une centrale pour plusieurs périodes de production.

## DESCRIPTION DETAILLEE D'AU MOINS UN MODE DE REALISATION DE L'INVENTION

Sauf précision contraire, un même élément apparaissant sur des figures différentes présente une référence unique. Dans ce qui suit, le temps peut être considéré comme une variable t continue allant de 0 à la période de production $T_{prod}$ ou bien discrète k allant de 1 à K. De plus, lorsque l'on s'intéresse à la valeur d'une grandeur physique f sur toute la période de production, les deux notations suivantes sont équivalentes :

$$\int_0^{T_{prod}} f(t)dt \sim \sum_{k=1}^{K} f(k)$$

En outre, une grandeur physique X sur la période de production $T_{prod}$ sera notée $X(T_{prod})$. Cette même grandeur physique à un instant t sera noté x(t) de sorte que $X(T_{prod}) = \int_0^{T_{prod}} x(t)\,dt$ ou $X(T_{prod}) = \sum_{k=1}^{K} x(k)$.

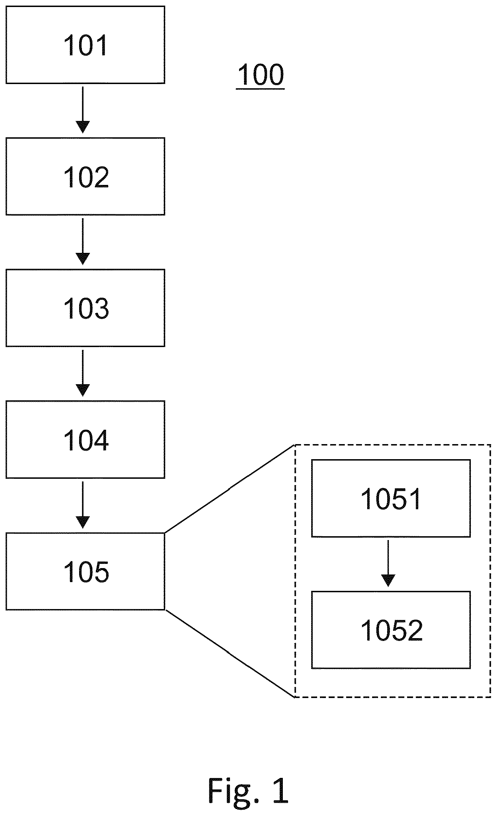

Un premier mode de réalisation selon un premier aspect de l'invention illustré en figure 1 concerne un procédé 100 de mesure de la performance d'une centrale à énergie renouvelable. Le procédé comporte une étape 101 de mesure de la production en énergie de la centrale sur une période de temps, dit période de production $T_{prod}$ ; une étape 102 de calcul d'un indicateur de production réelle $I_p$ à partir de la production mesurée lors de l'étape 101 de mesure de la production en énergie ; une étape 103 de calcul, à partir d'un modèle physique de la centrale, d'un indicateur de production théorique $I_{th}$ sur la période de production $T_{prod}$ ; une étape 104 de calcul du rapport R entre l'indicateur de production réelle $I_p$ et l'indicateur de production théorique $I_{th}$ sur la période de production $T_{prod}$ (autrement dit $R = \frac{I_p(T_{prod})}{I_{th}(T_{prod})}$ ) ; la mesure de la performance étant donnée par la valeur du rapport R entre l'indicateur de production réelle $I_p$ et l'indicateur de production théorique $I_{th}$.

Dans un mode de réalisation, l'indicateur de production réelle est obtenu à l'aide de la formule suivante :

$$I_p(T_{prod}) = \int_0^{T_{prod}} \left\{ k_1(t)p_{mesure}(t) - k_2(t)f\left(p_{mesure}(t), p_{prévision}(t)\right) \right\} dt$$

où $I_p$ est l'indicateur de production réelle, $p_{mesure}(t)$ est la puissance fournie à l'instant t, $p_{prévision}(t)$ est la puissance prévue à l'instant t, $T_{prod}$ est la période de production, $k_1(t)$ et $k_2(t)$ sont des facteurs de pondération positifs dépendants du temps et f est une fonction définissant une pénalité en fonction de la puissance fournie $p_{mesure}(t)$ et de la puissance prévue $p_{prévision}(t)$. Les facteurs de pondération dépendant du temps permettent de moduler le calcul de l'indicateur en fonction du temps sur la période de production $T_{prod}$, par exemple pour donner un poids plus important à la pénalité lorsque la demande en énergie est importante et donc tout écart à la production dommageable pour la stabilité du réseau.

Dans un exemple de réalisation, la fonction définissant une pénalité est donnée par :

$$f\left(p_{mesure}(t), p_{prévision}(t)\right) = p_{mesure}(t) - p_{prévision}(t)$$

Ainsi, la pénalité est égale à l'écart entre la prévision et la production effective.

Dans un mode de réalisation, les facteurs de pondération sont constants et tels que $k_1(t) = K_1$ et $k_2(t) = K_2$ et la fonction f dépend linéairement de la puissance fournie $p_{mesure}(t)$ et de la puissance prévue $p_{prévision}(t)$ de sorte que l'indicateur de production réelle peut s'exprimer à l'aide de la formule suivante :

$$I_p(T_{prod}) = K_1 P_{mesure}(T_{prod}) - K_2 f\left(P_{mesure}(T_{prod}), P_{prévision}(T_{prod})\right)$$

Dans ce mode de réalisation, le rapport R prend donc la forme suivante :

$$R = \frac{K_1 P_{mesure}(T_{prod}) - K_2 f\left(P_{mesure}(T_{prod}), P_{prévision}(T_{prod})\right)}{I_{th}(T_{prod})}$$

Dans un mode de réalisation $K_1 = K_2 = 1$.

Dans un mode de réalisation, l'indicateur de production théorique $I_{th}$ est fonction de la production théorique $p_{th}(t)$ à chaque instant t calculée à partir du modèle physique de la centrale. Dans un mode de réalisation, l'indicateur

de production théorique $I_{th}$ est calculé à partir de la production théorique $p_{th}(t)$ à un instant t maximisant la relation suivante (appelée production théorique optimale et notée $p_{th}^*$ ) :

$$\int_0^{T_{prod}} k_3(t)\, p_{th}(t)dt$$

où $k_3(t)$ est un coefficient de pondération positif dépendant du temps. Autrement dit :

$$\max\left(\int_0^{T_{prod}} k_3(t)\, p_{th}(t)dt\right) = \int_0^{T_{prod}} k_3(t)\, p_{th}^*(t)dt$$

Une fois la production théorique optimale $p_{th}^*(t)$ à un instant t déterminée, l'indicateur de production théorique $I_{th}$ sur la période de production $T_{prod}$ peut être calculé à l'aide de la formule suivante :

$$I_{th}(T_{prod}) = \int_0^{T_{prod}} p_{th}^*(t)$$

Dans un mode de réalisation, le coefficient $k_3(t)$ est une constante $\kappa_3$, par exemple $\kappa_3=1$. Dans un mode de réalisation alternatif, le coefficient $k_3(t)$ est fonction de la demande en énergie sur le réseau d'énergie auquel est raccordée la centrale à énergie renouvelable. Ainsi, l'indicateur de production théorique $I_{th}$ tient compte du fait qu'il peut être préférable de produire à certains moments de la période de production, par exemple lorsque la demande est importante.

Dans un mode de réalisation, le procédé 100 comprend également une étape 105 d'affichage de la performance de fonctionnement. De préférence l'étape 105 d'affichage de la performance de fonctionnement comporte une sous-étape 1051 d'affichage d'une information concernant la valeur du rapport R entre l'indicateur de production réelle $I_p$ et l'indicateur de production théorique $I_{th}$ ainsi que lesdits indicateurs; et une sous-étape 1052 d'affichage d'une information concernant l'évolution d'une ou plusieurs grandeurs physiques associées à la production en énergie sur la période de production $T_{prod}$.

Dans un mode de réalisation, la centrale à énergie renouvelable comporte au moins une batterie et une des grandeurs physiques associées à la production en énergie affichée lors de l'étape 105 d'affichage de la performance de fonctionnement est l'état de charge SOC de la batterie lors de la période de production $T_{prod}$ ainsi que l'état de charge de la batterie théorique $SOC_{th}$ pour ladite période. L'état de charge de la batterie théorique $SOC_{th}$ est déterminé à partir de la production théorique optimale $p_{th}^*(t)$ et correspond à l'état de charge de la batterie SOC qui aurait été mesurée si le fonctionnement de la centrale avait été conforme à celui prévu dans le calcul de la production théorique optimale $p_{th}^*(t)$.

Dans un mode de réalisation, la performance de la centrale est classée en quatre niveaux :

- $R \geq 0.85$, optimal;
- $0.85 > R \geq 0.75$, convenable ;
- $0.75 > R \geq 0.5$, détérioré ;
- $R < 0.5$, problématique.

Ainsi, le procédé permet d'identifier si le fonctionnement de la centrale est optimal (pas de défaillance), si le fonctionnement de la centrale est convenable, mais peut être amélioré (défaillance légère), si le fonctionnement de la centrale est détérioré, mais que cette dernière est encore fonctionnelle (défaillance modérée) ; et si le fonctionnement de la centrale est problématique, cette dernière n'étant plus fonctionnelle (défaillance grave). On notera que la mesure de la performance pour des périodes de production successives permet également de mesurer l'influence des dispositions éventuellement prises pour améliorer le fonctionnement de la centrale. De plus, comme nous allons le voir maintenant, la mesure de la performance peut également permettre de détecter une anomalie de fonctionnement de la centrale.

Pour cela, un mode de réalisation selon un deuxième aspect de l'invention concerne un procédé de détection d'une anomalie de fonctionnement d'une centrale à énergie renouvelable comprenant une étape de mesure de la performance d'une centrale à énergie renouvelable à l'aide d'un procédé 100 selon un premier aspect de l'invention ainsi qu'une étape de détection d'une anomalie de fonctionnement lorsque le rapport R entre l'indicateur de production réel $I_p$ et l'indicateur de production théorique $I_{th}$ est inférieur à une valeur prédéterminée. En effet, comme cela a été détaillé plus haut, ce rapport peut mettre en lumière des anomalies dans le fonctionnement de la centrale.

Dans un mode de réalisation, une anomalie est détectée lorsque le rapport entre l'indicateur de production réel $I_p$ et l'indicateur de production théorique $I_{th}$ est inférieur à 0.75 voire inférieur à 0.5.

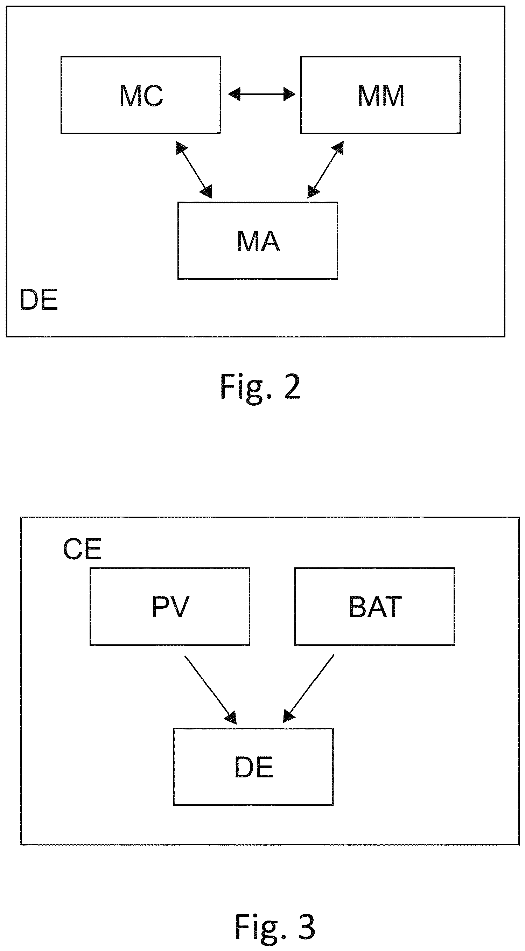

Afin de pouvoir mettre en œuvre le procédé selon un premier ou un deuxième aspect de l'invention, un mode de réalisation selon un troisième aspect de l'invention illustré à la figure 2 concerne un dispositif DE de mesure de performance d'une centrale et de détection d'une anomalie de fonctionnement d'une centrale à énergie renouvelable. Le dispositif DE comprend des moyens MM configurés pour mesurer de la production en énergie de la centrale sur une période de temps, dit période de production $T_{prod}$. La mesure peut notamment être effectuée à l'aide du système de contrôle commande de la centrale. Par exemple, la production réelle peut être mesurée par un capteur de puissance réactive au niveau de la sortie de la centrale.

Le dispositif DE comprend également des moyens MC configurés pour calculer un indicateur de production réelle $I_p$ à partir de la production mesurée ; des moyens MC configurés pour calculer, à partir d'un modèle physique de la centrale, un indicateur de production théorique $I_{th}$ sur la période de production $T_{prod}$ ; des moyens MC configurés pour calculer le rapport R entre l'indicateur de production réelle $I_p$ et l'indicateur de production théorique $I_{th}$ sur la période de production $T_{prod}$. Lesdits calculs peuvent être effectués à l'aide d'un processeur associé à une mémoire, d'un circuit intégré reprogrammable ou bien encore une carte ASIC (Application Specific Integrated Circuit ou circuit intégré propre à une application en français). Dans un mode de réalisation, les moyens MC de calcul comprennent un processeur associé à une mémoire dans laquelle est stocké un programme d'ordinateur comprenant des instructions qui conduisent le dispositif DE à exécuter les étapes des procédés précédemment détaillées. Le dispositif DE peut également comporter des moyens de saisie des données concernant le modèle physique de la centrale (ou toute autre donnée nécessaire à la mise en œuvre du dispositif) comme un clavier et/ou une souris associés à un écran ou bien encore un écran tactile. De manière alternative ou complémentaire, le dispositif DE peut comporter des moyens de connexion (par exemple une carte Ethernet ou WIFI) à un réseau (par exemple Internet), les paramètres concernant le modèle physique de la centrale étant récupérées sur un serveur, par exemple le serveur du fabricant de centrales. Dans tous les cas, les informations obtenues par les moyens de connexion et/ou de saisie sont accessibles aux moyens MC de calcul.

De plus, le dispositif DE comprend des moyens MA configurés pour afficher la performance de fonctionnement. Cet affichage peut se faire par l'intermédiaire d'un écran, par exemple d'un écran tactile. Alternativement ou de manière complémentaire, le dispositif DE selon un troisième aspect de l'invention peut être connecté à un réseau, par exemple un réseau de type GSM, et l'affichage peut alors s'effectuer sur un terminal déporté, par exemple une tablette ou un ordiphone (*smartphone* en anglais).

Enfin, les moyens MM,MC,MA de mesure, de calcul et d'affichage communiquent entre eux par l'intermédiaire d'un moyen de communication, par exemple un bus, un réseau local ou étendue de sorte que les mesures obtenues des moyens MM de mesure sont susceptibles d'être communiquées aux moyens MC de calcul et lesdits moyens MC de calcul sont susceptibles d'afficher des informations tels que la performance et/ou les indicateurs de production par l'intermédiaire des moyens MA d'affichage.

Dans un mode de réalisation, le dispositif DE comprend également des moyens configurés pour détecter une anomalie de fonctionnement lorsque le rapport entre l'indicateur de performance réel et l'indicateur de performance théorique est inférieur à une valeur prédéterminée. Cette détection peut être effectuée par les moyens MC de calcul du dispositif DE présentés auparavant. La valeur prédéterminée peut être saisie par un utilisateur en utilisant, par exemple à l'aide des moyens de saisis utilisés lors de la saisie des paramètres du modèle physique de la centrale. Dans ce cas, les moyens MA configurés pour afficher la performance de fonctionnement peuvent également être configurés pour afficher une anomalie de fonctionnement lorsqu'une telle anomalie est détectée.

Dans un exemple de réalisation illustré à la figure 3, la centrale CE est une centrale photovoltaïque comprenant au moins un panneau photovoltaïque PV et au moins une batterie BAT. La centrale comporte également un dispositif DE selon un troisième aspect de l'invention, ledit dispositif recevant des informations (production photovoltaïque, état de charge, etc.) de la part de la ou des batteries BAT et du ou des panneaux photovoltaïques PV. La puissance fournie par le ou les panneaux photovoltaïques PV à l'instant t sera noté $p_{pv}(t)$. L'état de charge SOC de la ou des batteries à un instant t sera noté $soc(t)$. Dans cet exemple de réalisation, le modèle physique de la ou des batteries BAT liant l'état de charge $soc(t)$ à un instant t à un état de charge à un instant $t + dt$ prend la forme de l'équation suivante :

$$soc(t + dt) = soc(t) + eff(t) \times \left( \frac{p_{bat}(t)}{C_{bat}} \right)$$

où soc appartient à l'ensemble [0,1], $p_{bat}(t)$ est la puissance fournie par la batterie BAT à un instant t, $C_{bat}$ est la capacité associée à la ou les batteries BAT et eff(t) est le rendement de la batterie BAT à l'instant t. Plus particulièrement, le rendement de la batterie ou des batteries à un instant t prend la forme de la fonction suivante :

$$\text{eff}(t) = f\big(p_{bat}(t), soc(t)\big)$$

Afin de modéliser le système, il est courant de diviser de manière discrète la période de production $T_{prod}$. Par exemple, pour une période de production d'une journée, l'on peut choisir une division du temps $\Delta t$ d'une minute. L'expression de l'état de charge devient alors :

$$soc(k + 1) = soc(k) + \text{eff}(k) \times \left(\frac{p_{bat}(k)}{C_{bat}}\right)$$

où k est entier positif appartenant à [1,K] avec K = 1440. Ainsi la période de production $T_{prod}$ est égale à $K \times \Delta t$ avec $\Delta t$ un pas de temps d'une minute. L'expression de l'efficacité devient quant à elle :

$$\text{eff}(k) = f\big(p_{bat}(k), soc(k)\big)$$

De plus, avec une période de production $T_{prod}$ égale à 24h, l'hypothèse que l'état de charge SOC en début (soc(1)) et fin (soc(K)) de période de production $T_{prod}$ doit être la même peut être faite. Cette condition peut s'exprimer sous la forme suivante :

$$soc(1) = soc(K) = soc_{mesure}(1)$$

où $soc_{mesure}(1)$ est l'état de charge initial mesurée au commencement de la période de production.

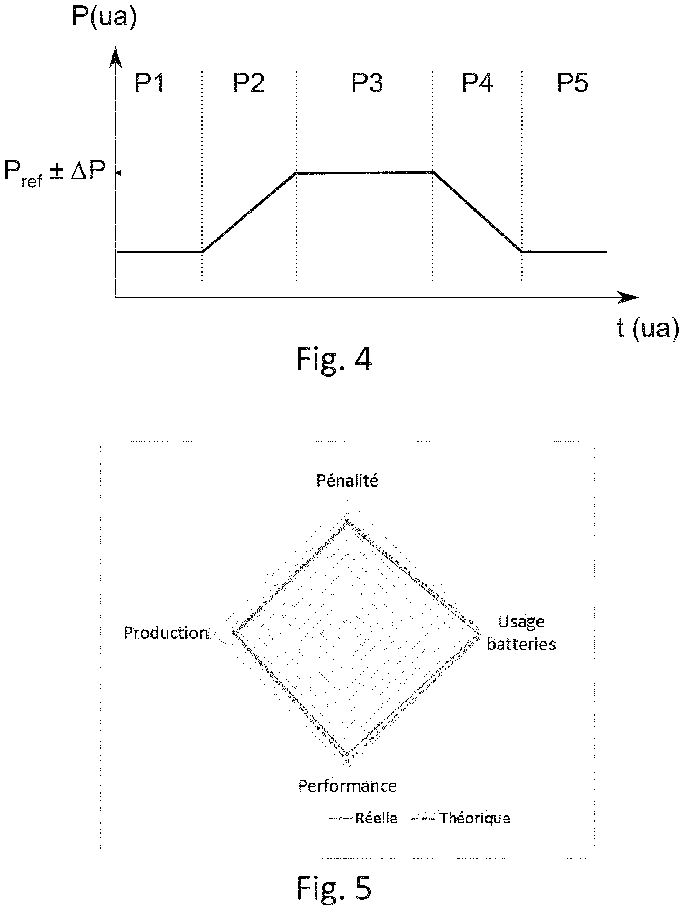

Le calcul de l'indicateur de production théorique $I_{th}$ va s'effectuer en fonction du modèle précédent, mais également en fonction d'un plan de production pour la période de production $T_{prod}$. Comme illustré à la figure 4, le plan de production peut, par exemple, être divisé en cinq phases :

- une première phase dite phase de préparation ;
- une deuxième phase dite phase de monté ;
- une troisième phase dite phase de stabilisation ;
- une quatrième phase dite phase de descente
- une cinquième phase dite phase de fin de production.

A partir de ce plan de production et de la mesure de la production sur la période considérée, il est possible de connaître la puissance prévue $P_{prévision}$ et donc l'indicateur de production réelle $I_p$ pour la période de production considérée.

Afin de déterminer la production théorique $p_{th}$ (et donc l'indicateur de production théorique $I_{th}$), il est nécessaire de simuler ces cinq phases. Pour cela, une variable binaire à chaque instant k noté $\delta(n, k)$ est utilisée avec n un entier égal à 1 pour la première phase, 2 pour la deuxième phase, 3 pour la troisième phase, 4 pour la quatrième phase et 5 pour la cinquième phase. La production théorique $p_{th}$ à chaque instant k peut alors être exprimée de la manière suivante :

$$p_{th}(k) = \sum_{n=1}^{5} \delta(n, k) \times \text{Phase}(n, k)$$

Avec :

- Phase $(1, k) = 0$
- Phase$(2, k + 1) \geq \text{ramp1} \times \text{Phase}(2, k)$ où $\text{ramp}_1$ est un coefficient positif associé à la rampe de la phase de monté ;
- $P_{ref} + \Delta P \geq \text{Phase}(3,k) \geq P_{ref} - \Delta P$ où $P_{ref}$ est la puissance de référence lors de la phase de stabilisation et $\Delta P$ est la marge d'erreur (cette dernière est généralement fixée par le gestionnaire et/ou le propriétaire de la centrale) ;

- Phase$(4, k + 1) \le$ ramp$_2 \times$ Phase$_4(4,k)$ où ramp$_2$ est un coefficient négatif associé à la rampe de la phase de monté ;
- Phase$(5, k) = 0$ ;
- $\sum_{n=1}^{5} \delta(n, k) = 1 \ \forall k \in [1, K]$ .

Dans un mode de réalisation, la marge d'erreur $\Delta P$ est égale à 5% de la puissance de référence $P_{ref}$.

De plus, la production théorique $p_{th}(k)$ à un instant k est égale à la puissance fournie par le ou les panneaux solaire $p_{pv}(k)$ à un instant k et la puissance fournie par la ou les batteries $p_{bat}(k)$ à un instant k de sorte que :

$$p_{th}(k) = p_{pv}(k) + p_{bat}(k)$$

On calcule ensuite un indicateur de la performance théorique en déterminant la production théorique maximisant la relation suivante :

$$\sum_{k=1}^{K} p_{th}(k) \times k_3(k)$$

Autrement dit, on détermine la fonction $p_{th}(k)$ maximisant la relation précédente, noté $p_{th}^{*}(k)$ , puis on calcule l'indicateur de production théorique comme étant :

$$I_{th}(T_{prod}) = \sum_{k=1}^{K} p_{th}^{*}(k)$$

Une fois cet indicateur de production théorique $I_{th}$ déterminé, il est possible de calculer la valeur du rapport entre l'indicateur de production réelle et l'indicateur de production théorique :

$$R = \frac{I_p(T_{prod})}{I_{th}(T_{prod})}$$

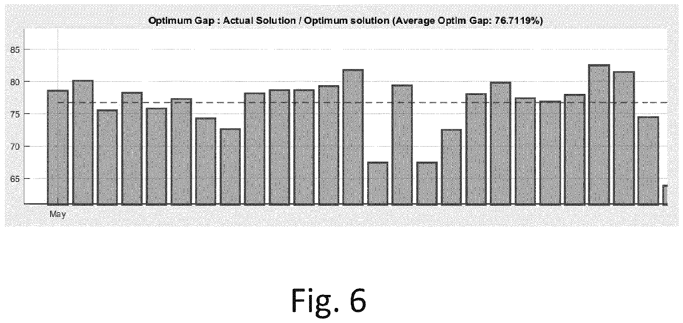

Il est alors possible de mesurer la performance de la centrale photovoltaïque et éventuellement de détecter une anomalie dans son fonctionnement. Dans cet exemple de réalisation, il sera également possible de réaliser une étape 105 d'affichage comme illustré à la figure 5. Sur cette figure, l'affichage présente, à l'aide d'un graphique dit radar, l'utilisation de la batterie, l'énergie produite (libellée production), la pénalité ainsi que la performance, c'est-à-dire le la valeur du rapport R entre l'indicateur de production réelle $I_p$ et l'indicateur de production théorique $I_{th}$ durant une période de production. De plus, lorsque les périodes de production se succèdent, l'étape d'affichage peut également faire apparaitre l'évolution de la performance au cours de ces différentes périodes de productions comme cela est illustré à la figure 6. Dans l'exemple de la figure 6, chaque période de production est représentée par un histogramme dont la hauteur est représentative de la performance (ici exprimée en %) lors de la période de production considérée. Comme cela a déjà été mentionné, un tel affichage permet notamment de mesurer l'influence des dispositions éventuellement prises pour améliorer le fonctionnement de la centrale, mais également de repérer de manière rapide les périodes de production lors desquelles un fonctionnement défaillant de la centrale a été observé.

**Revendications**

1. Procédé (100) de mesure de la performance d'une centrale à énergie renouvelable comprenant :

   - une étape (101) de mesure de la production en énergie de la centrale sur une période de temps, dite période de production $T_{prod}$ ;
   - une étape (102) de calcul d'un indicateur de production réelle à partir de la production mesurée lors de l'étape

(101) de mesure de la production en énergie ;

- une étape (103) de calcul d'un indicateur de production théorique sur la période de production $T_{prod}$ à partir d'un modèle physique de la centrale;

- une étape (104) de calcul du rapport entre l'indicateur de production réelle et l'indicateur de production théorique sur la période de production $T_{prod}$ ;

la mesure de la performance étant donnée par la valeur du rapport entre l'indicateur de production réelle et l'indicateur de production théorique, le procédé étant **caractérisé en ce que** l'indicateur de production réelle est obtenu à l'aide de la formule suivante :

$$I_p\big(T_{prod}\big) = \int_0^{T_{prod}} \Big\{ k_1(t) p_{mesure}(t) - k_2(t) f\Big( p_{mesure}(t), p_{prévision}(t)\Big) \Big\} dt$$

où $I_p$ est l'indicateur de production réelle, $p_{mesure}(t)$ est la puissance fournie à l'instant t, $p_{prévision}(t)$ est la puissance prévue à l'instant t, $T_{prod}$ est la période de production, $k_1(t)$ et $k_2(t)$ sont des facteurs de pondération positifs dépendants du temps et f est une fonction définissant une pénalité en fonction de la puissance fournie $p_{mesure}(t)$ et de la puissance prévue $p_{prévision}(t)$.

2. Procédé selon la revendication précédente **caractérisé en ce qu'**il comprend une étape (105) d'affichage de la performance de fonctionnement.

3. Procédé selon l'une des revendications précédentes **caractérisé en ce que** l'indicateur de production théorique est fonction de la production théorique sur la période de production $T_{prod}$ calculée à partir du modèle physique de la centrale.

4. Procédé selon l'une des revendications précédentes **caractérisé en ce que** l'indicateur de production théorique est calculé à partir de la production théorique $p_{th}(t)$ à un instant t maximisant la relation suivante, notée $p_{th}^*$ :

$$\int_0^{T_{prod}} k_3(t)\, p_{th}(t) dt$$

où $k_3(t)$ est un coefficient de pondération positif dépendant du temps et $p_{th}(t)$ est la production théorique à un temps t, l'indicateur de production étant égal à :

$$I_{th}\big(T_{prod}\big) = \int_0^{T_{prod}} p_{th}^*(t)$$

5. Procédé selon l'une des revendications précédentes **caractérisé en ce que** l'étape (105) d'affichage de la performance de fonctionnement comporte :

- une sous-étape (1051) d'affichage d'une information concernant la valeur de l'indicateur de production réelle et/ou théorique ; et

- une sous-étape (1052) d'affichage d'une information concernant l'évolution d'une ou plusieurs grandeurs physiques associées à la production en énergie sur la période de production $T_{prod}$.

6. Procédé selon la revendication précédente dans lequel la centrale à énergie renouvelable comporte au moins une batterie, le procédé étant **caractérisé en ce qu'**une des grandeurs physiques associées à la production en énergie affichée lors de l'étape (105) d'affichage de la performance de fonctionnement est l'état de charge (SOC) de la batterie lors de la période de production $T_{prod}$ ainsi que l'état de charge de la batterie théorique pour ladite période.

7. Procédé de détection d'une anomalie de fonctionnement d'une centrale à énergie renouvelable **caractérisé en ce qu'**il comprend :

- une étape de mesure de la performance d'une centrale à énergie renouvelable à l'aide d'un procédé selon l'une des revendications précédentes ;
- une étape de détection d'une anomalie de fonctionnement lorsque le rapport entre l'indicateur de performance réel et l'indicateur de performance théorique est inférieur à une valeur prédéterminée.

8. Dispositif de mesure de la performance d'une centrale à énergie renouvelable **caractérisé en ce qu'**il comprend des moyens configurés pour :

- mesurer de la production en énergie de la centrale sur une période de temps, dite période de production $T_{prod}$ ;
- calculer un indicateur de production réelle à partir de la production mesurée lors de la mesure de la production en énergie ;
- calculer, à partir d'un modèle physique de la centrale, un indicateur de production théorique sur la période de production $T_{prod}$ ;
- calculer le rapport entre l'indicateur de production réelle et l'indicateur de production théorique sur la période de production $T_{prod}$ ;
la mesure de la performance étant donnée par la valeur du rapport entre l'indicateur de production réelle et l'indicateur de production théorique, le dispositif étant **caractérisé en ce que** l'indicateur de production réelle est obtenu à l'aide de la formule suivante :

$$I_p\left(T_{prod}\right) = \int_0^{T_{prod}} \left\{k_1(t)p_{mesure}(t) - k_2(t)f\left(p_{mesure}(t), p_{prévision}(t)\right)\right\} dt$$

où $I_p$ est l'indicateur de production réelle, $p_{mesure}(t)$ est la puissance fournie à l'instant t, $p_{prévision}(t)$ est la puissance prévue à l'instant t, $T_{prod}$ est la période de production, $k_1(t)$ et $k_2(t)$ sont des facteurs de pondération positifs dépendants du temps et f est une fonction définissant une pénalité en fonction de la puissance fournie $p_{mesure}(t)$ et de la puissance prévue $p_{prévision}(t)$.

9. Produit programme d'ordinateur comprenant des instructions qui conduisent le dispositif selon la revendication précédente à exécuter les étapes du procédé selon l'une des revendications 1 à 6.

10. Support lisible par ordinateur, sur lequel est enregistré le programme d'ordinateur selon la revendication précédente.

**Patentansprüche**

1. Messverfahren (100) der Leistung einer Zentrale für erneuerbare Energie, umfassend:

- einen Messschritt (101) der Energieproduktion der Zentrale über einen Zeitraum, bezeichnet als Produktionszeitraum $T_{prod}$;
- einen Berechnungsschritt (102) eines Indikators der realen Produktion ausgehend von der Produktion, die beim Messschritt (101) der Energieproduktion gemessen wird;
- einen Berechnungsschritt (103) eines Indikators der theoretischen Produktion über die Produktionsperiode $T_{prod}$ ausgehend von einem physischen Modell der Zentrale;
- einen Berechnungsschritt (104) des Verhältnisses zwischen dem Indikator der realen Produktion und dem Indikator der theoretischen Produktion über die Produktionsperiode $T_{prod}$;
wobei die Messung der Leistung durch den Wert des Verhältnisses zwischen dem Indikator der realen Produktion und dem Indikator der theoretischen Produktion angegeben wird, wobei das Verfahren **dadurch gekennzeichnet ist, dass** der Indikator der realen Produktion mithilfe der folgenden Formel erhalten wird:

$$I_p\left(T_{prod}\right) = \int_0^{T_{prod}} \left\{k_1(t)p_{mesure}(t) - k_2(t)f\left(p_{mesure}(t), p_{prévision}(t)\right)\right\} dt$$

wobei $I_p$ der Indikator der realen Produktion ist, $P_{mesure}(t)$ die im Moment t gelieferte Leistung ist, $P_{prévision}(t)$ die im Moment t vorgesehene Leistung ist, $T_{prod}$ die Produktionsperiode ist, $k_1(t)$ und $k_2(t)$ positiven Gewichtungsfaktoren sind, die von der Zeit abhängen, und f eine Funktion ist, die eine Strafe in Abhängigkeit von der gelieferten Leistung Pmesure (t) und der vorgesehenen Leistung $P_{prévision}$ (t) definiert.

2. Verfahren gemäß dem voranstehenden Anspruch, **dadurch gekennzeichnet, dass** es einen Anzeigeschritt (105) der Betriebsleistung umfasst.

3. Verfahren gemäß einem der voranstehenden Ansprüche, **dadurch gekennzeichnet, dass** der Indikator der theoretischen Produktion von der theoretischen Produktion über die Produktionsperiode $T_{prod}$ abhängig ist, die ausgehend von dem physischen Modell der Zentrale berechnet wird.

4. Verfahren gemäß einem der voranstehenden Ansprüche, **dadurch gekennzeichnet, dass** der Indikator der theoretischen Produktion ausgehend von der theoretischen Produktion $p_{th}$ (t) zu einem Moment t berechnet wird, der die folgende Relation maximiert, bezeichnet mit $p_{th}$:

$$\int_0^{T_{prod}} k_3(t)\, p_{th}(t)dt$$

wobei $k_3$ (t) ein positiver Gewichtungskoeffizient ist, der von der Zeit abhängig ist, und $p_{th}$ (t) die theoretische Produktion zu einer Zeit t ist, wobei der Produktionsindikator gleich:

$$I_{th}(T_{prod}) = \int_0^{T_{prod}} p_{th}^*(t)$$

ist.

5. Verfahren gemäß irgendeinem der voranstehenden Ansprüche, **dadurch gekennzeichnet, dass** der Anzeigeschritt (105) der Betriebsleistung umfasst:

   - einen Anzeige-Teilschritt (1051) einer Information bezüglich des Wertes des Indikators der realen und/oder theoretischen Produktion; und
   - einen Anzeige-Teilschritt (1052) einer Information bezüglich der Entwicklung einer oder mehrerer physikalischer Größen, die der Energieproduktion über die Produktionsperiode $T_{prod}$ zugeordnet werden.

6. Verfahren gemäß dem voranstehenden Anspruch, bei dem die Zentrale für erneuerbare Energie wenigstens eine Batterie umfasst, wobei das Verfahren **dadurch gekennzeichnet ist, dass** eine der physikalischen Größen, die der Energieproduktion zugeordnet sind, die beim Anzeigeschritt (105) der Betriebsleistung angezeigt wird, der Lastzustand (SOC) der Batterie in der Produktionsperiode $T_{prod}$ sowie der theoretische Lastzustand der Batterie für die genannte Periode ist.

7. Detektionsverfahren einer Betriebsanomalie einer Zentrale für erneuerbare Energie, **dadurch gekennzeichnet, dass** sie umfasst:

   - einen Messschritt der Leistung einer Zentrale für erneuerbare Energie mithilfe eines Verfahrens gemäß einem der voranstehenden Ansprüche;
   - einen Detektionsschritt einer Betriebsanomalie, wenn das Verhältnis zwischen dem Indikator der realen Leistung und dem Indikator der theoretischen Leistung unter einem vorbestimmten Wert liegt.

8. Messvorrichtung der Leistung einer Zentrale für erneuerbare Energie, **dadurch gekennzeichnet, dass** sie Mittel umfasst, die ausgestaltet sind zum:

   - Messen der Energieproduktion der Zentrale über eine zeitliche Periode, bezeichnet als Produktionsperiode $T_{prod}$;
   - Berechnen eines Indikators der realen Produktion ausgehend von der Produktion, die bei der Messung der Energieproduktion gemessen wird;
   - Berechnen eines Indikators der theoretischen Produktion über die Produktionsperiode $T_{prod}$ ausgehend von einem physikalischen Modell der Zentrale;
- Berechnen des Verhältnisses zwischen dem Indikator der realen Produktion und dem Indikator der theoretischen Produktion über die Produktionsperiode $T_{prod}$;
wobei die Messung der Leistung durch den Wert des Verhältnisses zwischen dem Indikator der realen Produktion und dem Indikator der theoretischen Produktion angegeben wird, wobei die Vorrichtung **dadurch gekennzeichnet ist, dass** der Indikator der realen Produktion mithilfe der folgenden Formel erhalten wird:

$$I_p(T_{prod}) = \int_0^{T_{prod}} \left\{ k_1(t) p_{mesure}(t) - k_2(t) f\left( p_{mesure}(t), p_{prévision}(t) \right) \right\} dt$$

wobei $I_p$ der Indikator der realen Produktion ist, $P_{mesure}(t)$ die im Moment t gelieferte Leistung ist, $P_{prévision}(t)$ die im Moment t vorgesehene Leistung ist, $T_{prod}$ die Produktionsperiode ist, $k_1(t)$ und $k_2(t)$ positive Gewichtungsfaktoren sind, die von der Zeit abhängen, und f eine Funktion ist, die eine Strafe in Abhängigkeit von der gelieferten Leistung $P_{mesure}(t)$ und der vorgesehenen Leistung $P_{prévision}(t)$ definiert.

9. Computerprogramm-Produkt, umfassend Anweisungen, die die Vorrichtung gemäß dem voranstehenden Anspruch dazu veranlassen, die Schritte des Verfahrens gemäß einem der Ansprüche 1 bis 6 auszuführen.

10. Per Computer lesbarer Träger, auf dem das Computerprogramm gemäß dem voranstehenden Anspruch gespeichert ist.

**Claims**

1. Method (100) for measuring the performance of a renewable energy power plant including:

   - a step (101) of measuring the energy production of the power plant over a time period, designated production period $T_{prod}$;
   - a step (102) of calculating an actual production indicator from the production measured during the step (101) of measuring the energy production;
   - a step (103) of calculating a theoretical production indicator over the production period $T_{prod}$ from a physical model of the power plant;
   - a step (104) of calculating the ratio between the actual production indicator and the theoretical production indicator over the production period $T_{prod}$;
   the measurement of the performance being given by the value of the ratio between the actual production indicator and the theoretical production indicator, the method being **characterised in that** the actual production indicator is obtained using the following formula:

$$I_p(T_{prod}) = \int_0^{T_{prod}} \left\{ k_1(t) p_{measurement}(t) \right.$$
$$\left. - k_2(t) f\left( p_{measurement}(t), p_{forecast}(t) \right) \right\} dt$$

   where $I_p$ is the actual production indicator, $p_{measurement}(t)$ is the supplied power at the instant t, $p_{forecast}(t)$ is the forecast power at the instant t, $T_{prod}$ is the production period, $k_1(t)$ and $k_2(t)$ are time dependent positive weighting factors and f is a function defining a penalty as a function of the supplied power $p_{measurement}(t)$ and the forecast power $p_{forecast}(t)$.

2. Method according to the preceding claim **characterised in that** it includes a step (105) of displaying the operating performance.

3. Method according to one of the preceding claims **characterised in that** the theoretical production indicator is a function of the theoretical production over the production period $T_{prod}$ calculated from the physical model of the power plant.

4. Method according to one of the preceding claims **characterised in that** the theoretical production indicator is calculated from the theoretical production $p_{th}(t)$ at an instant t maximising the following relationship, noted $p_{th}^*$ :

$$\int_0^{T_{prod}} k_3(t)\, p_{th}(t)dt$$

where $k_3(t)$ is a time dependent positive weighting coefficient and $p_{th}(t)$ is the theoretical production at a time t, the production indicator being equal to:

$$I_{th}(T_{prod}) = \int_0^{T_{prod}} p_{th}^*(t)$$

5. Method according to one of the preceding claims **characterised in that** the step (105) of displaying the operating performance comprises:

   - a sub-step (1051) of displaying information concerning the value of the actual and/or theoretical production indicator; and
   - a sub-step (1052) of displaying information concerning the evolution of one or more physical quantities associated with the energy production over the production period $T_{prod}$.

6. Method according to the preceding claim wherein the renewable energy power plant comprises at least one battery, the method being **characterised in that** one of the physical quantities associated with the energy production displayed during the step (105) of displaying the operating performance is the state of charge (SOC) of the battery during the production period $T_{prod}$ and the theoretical state of charge of the battery for said period.

7. Method for detecting an operational malfunction of a renewable energy power plant **characterised in that** it includes:

   - a step of measuring the performance of a renewable energy power plant using a method according to one of the preceding claims;
   - a step of detecting an operational malfunction when the ratio between the actual performance indicator and the theoretical performance indicator is below a predetermined value.

8. Device for measuring the performance of a renewable energy power plant **characterised in that** it includes means configured to:

   - measure the energy production of the power plant over a time period, designated production period $T_{prod}$;
   - calculate an actual production indicator from the production measured during the measurement of the energy production;
   - calculate, from a physical model of the power plant, a theoretical production indicator over the production period $T_{prod}$;
   - calculate the ratio between the actual production indicator and the theoretical production indicator over the production period $T_{prod}$;
   the measurement of the performance being given by the value of the ratio between the actual production indicator and the theoretical production indicator, the device being **characterised in that** the actual production indicator is obtained using the following formula:

$$I_p(T_{prod}) = \int_0^{T_{prod}} \{k_1(t)p_{measurement}(t)$$

$$- k_2(t)f(p_{measurement}(t), p_{forecast}(t))\}dt$$

where $I_p$ is the actual production indicator, $p_{measurement}(t)$ is the supplied power at the instant t, $p_{forecast}(t)$ is the forecast power at the instant t, $T_{prod}$ is the production period, $k_1(t)$ and $k_2(t)$ are time dependent positive weighting factors and f is a function defining a penalty as a function of the supplied power $p_{measurement}(t)$ and the forecast power $p_{forecast}(t)$.

9. Computer programme product including instructions which lead the device according to the preceding claim to execute the steps of the method according to one of claims 1 to 6.

10. Computer readable support, on which the computer programme according to the preceding claim is recorded.

Fig. 1

Fig. 2

Fig. 3

Fig. 4

Fig. 5

Optimum Gap : Actual Solution / Optimum solution (Average Optim Gap: 76.7119%)

Fig. 6

**EP 3 457 153 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010185337 A1
- EP 3016278 A1